Europäisches Patentamt

European Patent Office

Office européen des brevets

(11) Veröffentlichungsnummer: **0 272 504**
**A1**

## (12) EUROPÄISCHE PATENTANMELDUNG

(21) Anmeldenummer: **87117711.9**

(22) Anmeldetag: **30.11.87**

(51) Int. Cl.⁴: **G01R 21/127 , G01R 21/133**

(30) Priorität: **11.12.86 DE 3642425**

(43) Veröffentlichungstag der Anmeldung:
**29.06.88 Patentblatt 88/26**

(84) Benannte Vertragsstaaten:
**DE GB**

(71) Anmelder: **Siemens Aktiengesellschaft Berlin
und München
Wittelsbacherplatz 2
D-8000 München 2(DE)**

(72) Erfinder: **Förder Walter, Dipl.-Phys.
Gewendeweg 74
D-8510 Fürth(DE)**
Erfinder: **Steinmüller, Günter, Dipl.-Ing. (FH)
Laufamholzstrasse 65
D-8500 Nürnberg(DE)**
Erfinder: **Windsheimer, Klaus, Dipl.-Ing. (FH)
Pappenheimerstrasse 43
D-8500 Nürnberg(DE)**

(54) **Elektronischer Elektrizitätszähler mit einer elektromagnetischen Zählerstandsanzeige.**

(57) Die wesentlichen Verbraucher eines Elektrizitätszählers (Leuchtdiode und elektromagnetische Zählerstandsanzeige) werden bisher gleichzeitig angesteuert mit der Folge einer großen Strombelastung des Netzteils. Die Erfindung betrifft die Reduzierung der maximalen Stromaufnahme eines Elektrizitätszählers.

Bei der erfindungsgemäßen Anordnung werden Strom (I) und Spannung (U) über eine Anpaßstufe (1) einem Multiplizierer (2) und dessen Ausgangssignal einem Quantisierer (3) zugeführt. Das leistungsproportionale Ausgangssignal des Quantisierers (3) wird einer elektromagnetischen Zählerstandsanzeige (4) und über eine Sperre (5) einer optischen Anzeige (6) zugeführt. Die Sperre (5) verhindert das gleichzeitige Ansteuern von Zählerstandsanzeige (4) und optischer Anzeige (6). Hierdurch wird erreicht, daß die maximale Stromaufnahme reduziert wird und daß das Netzteil für eine geringere maximale Stromabgabe dimensioniert werden kann.

FIG 1

## Elektronischer Elektrizitätszähler mit einer elektromagnetischen Zählerstandsanzeige

Die Erfindung betrifft einen elektronischen Elektrizitätszähler mit einer Ansteuervorrichtung, die eine leistungsproportionale Impulsfolge an eine elektromagnetische Zählerstandsanzeige und eine optische Anzeige abgibt.

Ein derartiger Aufbau ist bekannt aus der deutschen Offenlegungsschrift 27 47 385.

Strom und Spannung werden in einer Anpaßstufe auf Größen transformiert, die von einem elektronischen Multiplizierer verarbeitet werden können. Das Ausgangssignal des Multiplizierers wird einem Quantisierer zugeführt, so daß am Ausgang des Quantisierers eine leistungsproportionale Impulsfolge ableitbar ist. Diese leistungsproportionale Impulsfolge wird einer Untersetzerstufe zugeführt, deren einer Ausgang eine Leuchtdiode ansteuert und deren zweiter Ausgang einen elektronischen Schalter ansteuert, der eine elektromagnetische Spule schaltet.

Nachteil dieser Ausführungsform ist, daß die Leuchtdiode und die elektromagnetische Spule zum Weiterschalten der Anzeige gleichzeitig angesteuert werden können mit der Folge einer hohen Impulsbelastung für die Spannungsversorgung. Dabei stellen die blinkende Leuchtdiode und der elektromagnetische Antrieb der Anzeige die wesentlichen Verbraucher dar, so daß das Netzteil im wesentlichen auf den Summenstrom von Leuchtdiode und elektromagnetischem Antrieb ausgelegt werden muß. Die Schaltungen elektronischer Elektrizitätszähler sind auf eine möglichst geringe Stromaufnahme ausgelegt.

Aufgabe der Erfindung ist es daher, die maximale Stromaufnahme des Elektrizitätszählers zu verringern.

Diese Aufgabe wird erfindungsgemäß dadurch gelöst, daß der Zählerstandsanzeige bzw. der optischen Anzeige eine Sperre vorgeschaltet ist, die ein gleichzeitiges Ansteuern von Zählerstandsanzeige und optischer Anzeige verhindert. Da es nicht zwingend erforderlich ist, die optische Anzeige und den Antrieb der Zählerstandsanzeige gleichzeitig anzusteuern, kann durch zeitliche Koordination der Ströme erreicht werden, daß die maximale Stromaufnahme reduziert wird.

Vorteilhafterweise ist die Sperre in Serie zur optischen Anzeige geschaltet und wird von einem Ansteuerimpuls für die Zählerstandsanzeige angesteuert. Diese Schaltungsmaßnahme ist besonders zweckmäßig, da das Weiterschalten der Zählerstandsanzeige eine höhere Priorität gegenüber der optischen Anzeige hat.

Es ist vorteilhaft, die Zählerstandsanzeige an zwei Ausgänge der Ansteuervorrichtung anzuschließen, wobei der Signalpegel beider Ausgänge zwischen binären Werten wechseln kann und das Signal der optischen Anzeige gesperrt wird, wenn die beiden Ausgänge unterschiedliche Signalpegel aufweisen. Hierdurch wird erreicht, daß die Zählerstandsanzeige bei jedem Ansteuersignal weitergeschaltet wird und in den Schaltpausen die optische Anzeige angesteuert werden kann.

Bei einem elektronischen Elektrizitätszähler, bei dem die leistungsproportionale Impulsfolge der Zählerstandsanzeige und der optischen Anzeige über einen Teiler zugeführt ist und die Zählerstandsanzeige und die optische Anzeige an Ausänge des Teilers mit verschiedenen Teilerverhältnissen angeschlossen sind, ist es vorteilhaft, einen ersten Ausgang des Teilers mit einem D-Eingang eines Schieberegisters und mit einem ersten Anschluß der Zählerstandsanzeige zu verbinden, einen Ausgang des Schieberegisters mit einem zweiten Anschluß der Zählerstandsanzeige zu verbinden und den Ausgang eines Taktgebers mit einem Clock-Eingang des Schieberegisters zu verbinden. Mit dem Schieberegister wird auf einfache Weise die Länge der Ansteuerimpulse festgelegt.

Zweckmäßigerweise ist ein erster Eingang eines Exklusiv-ODER-Gatters mit dem ersten Anschluß der Zählerstandsanzeige und ein zweiter Eingang des Exklusiv-ODER-Gatters mit dem zweiten Anschluß der Zählerstandsanzeige verbunden, wobei ein Ausgangssignal des Exklusiv-ODER-Gatters die Sperre in den Sperrzustand versetzt. Durch diese Schaltungsmaßnahme wird erreicht, daß das Signal der optischen Anzeige gesperrt wird, wenn an den Eingängen des Exklusiv-ODER-Gatters unterschiedliche Signalpegel anliegen, d.h. die Zählerstandsanzeige angesteuert wird.

Ein Ausführungsbeispiel der Erfindung wird nachfolgend anhand der FIG 1 bis 9 näher erläutert.

FIG 1 zeigt den schematischen Aufbau eines Ausführungsbeispiels der Erfindung.

FIG 2 zeigt ein detailliertes Ausführungsbeispiel der Erfindung.

FIG 3 bis 9 zeigen ein Impulsdiagramm des Ausführungsbeispiels der Erfindung.

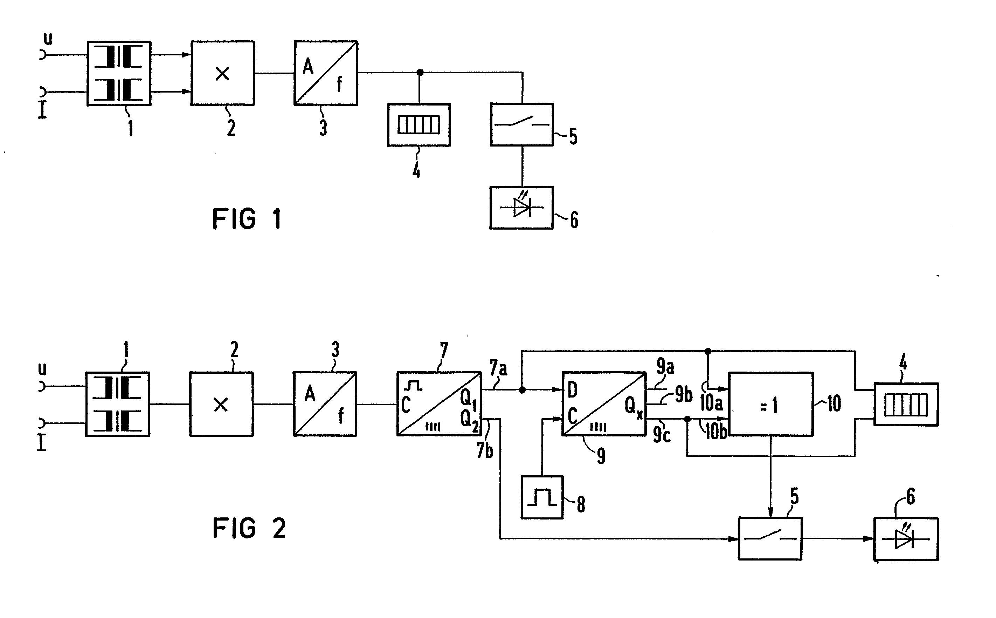

Bei einem Ausführungsbeispiel nach FIG 1 werden Strom I und Spannung U in einer Anpaßstufe 1 auf Größen transformiert, die von dem elektronischen Multiplizierer 2 verarbeitet werden können. Der Multiplizierer bildet ein Produkt aus Strom I und Spannung U, d.h. die elektrische Leistung. Das Ausgangssignal des Multiplizierers 2 wird einem Quantisierer 3 zugeführt, an dessen Ausgang eine leistungsproportionale Impulsfolge ansteht. Dieser Schaltungsaufbau ist bekannt aus "Technisches Messen atm", 1978, Heft 11, Seiten 407-411, Günter Steinmüller "Ein genauer elektronischer Energiezähler".

Das leistungsproportionale Ausgangssignal des Quantisierers 3 wird einer Zählerstandsanzeige 4 und über eine Sperre 5 einer optischen Anzeige 6 zugeführt. Die Sperre 5 sperrt das Signal zur optischen Anzeige 6, wenn die Zählerstandsanzeige 4 angesteuert wird. Als elektromagnetische Zählerstandsanzeige (4) kann z.B. ein von einem Schrittmotor angetriebenes Rollenzählwerk verwendet werden.

Das Ausführungsbeispiel nach FIG 2 ist bis zum Quantisierer 3 identisch mit dem Ausführungsbeispiel nach FIG 1. Einem Clock-Eingang eines binären Teilers 7, der als Zähler ausgeführt ist, wird das Ausgangssignal des Quantisierers 3 zugeführt. Ein Ausgang 7a des Teilers 7 ist mit einem D-Eingang eines Schieberegisters 9, einem ersten Eingang 10a eines Exklusiv-ODER-Gatters 10 und einem ersten Anschluß der Zählerstandsanzeige 4 verbunden. Ein Ausgang 7b des Teilers 7 ist mit einem Eingang der Sperre 5 verbunden. Das Ausgangssignal der Sperre 5 steuert die optische Anzeige 6 an. Der Ausgang eines Taktgebers 8 ist mit dem Clock-Eingang des Schieberegisters 9 verbunden. Ein Ausgang des Schieberegisters 9 ist mit einem zweiten Eingang 10b des Exklusiv-ODER-Gatters 10 und einem zweiten Anschluß der Zählerstandsanzeige 4 verbunden. Ein Ausgangssignal des Exklusiv-ODER-Gatters 10 steuert die Sperre 5.

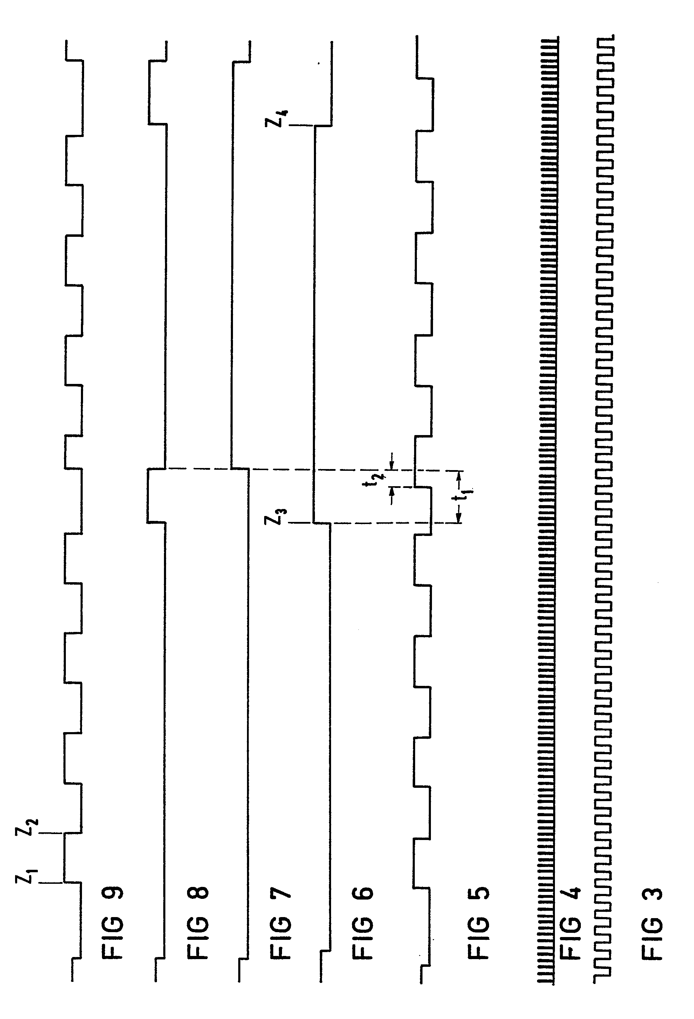

FIG 4 zeigt die Ausgangsimpulse des Quantisierers 3. Jeder Impuls aus dem Quantisierer 3 - schaltet den Zähler 7 um einen Zählschritt weiter. Wie aus FIG 9 zu ersehen ist, wird nach dem Erreichen eines ersten vorbestimmten Zählwertes (Z1) des Zählers 7 an dem Ausgang 7b des Zählers 7 ein H-Signal erhalten und über die Sperre 5 zur optischen Anzeige geführt. Nach einer bestimmten Anzahl von Impulsen (Z2) aus dem Quantisierer 3 wird am Ausgang 7b des Zählers L-Signal erhalten. Erreicht der Zähler 7 einen dritten vorbestimmten Zählwert (Z3), so erhält man - wie in FIG 6 dargestellt - an dem zweiten Ausgang 7a ein H-Signal. Dieses Signal schaltet, da das Ausgangssignal des Schieberegisters 9 - wie in FIG 7 dargestellt - L-Signal hat, die Zählerstandsanzeige 4. Durch die Signalpegel H und L (FIG 6,7) am Eingang des Exklusiv-ODER-Gatters 10 wird - wie in FIG 8 dargestellt - am Ausgang des Gatters 10 (FIG 8) H-Signal erhalten, welches die Sperre 5 steuert und damit den Signalweg von dem Zählerausgang 7b zur optischen Anzeige 6 unterbricht. Durch den in FIG 3 dargestellten freien Takt am Ausgang des Taktgebers 8 wird das H-Signal (FIG 6) am D-Eingang des Schieberegisters 9 nacheinander auf die Ausgänge 9a bis 9c geschaltet. Wird der Ausgang 9c erreicht (FIG 7), so wird an diesem H-Signal erhalten. Damit steht an beiden Eingängen der Anzeigevorrichtung H-Signal an, so daß diese nicht mehr angesteuert wird und die Sperre 5 durch das L-Signal (FIG 8) am Ausgang des Exklusiv-ODER-Gatters 10 aufgehoben wird. Durch das Schieberegister 9 wird also die Dauer des Ansteuerimpulses der Zählerstandsanzeige 4 begrenzt. Wie ein Vergleich der FIG 5 (Ansteuerimpuls vor der Sperre) und FIG 9 (Ansteuerimpuls nach der Sperre) zeigt, bleibt der Ansteuerimpuls für die optische Anzeige 6 in den meisten Fällen unverändert. Lediglich der während der Zeitspanne $t_1$ auftretende Ansteuerimpuls für die Zählerstandsanzeige 4 verkürzt den Ansteuerimpuls für die optische Anzeige 6 um die Zeitspanne $t_2$. Das damit verbundene kürzere Aufleuchten der optischen Anzeige 6 stört in der Praxis nicht. Erreicht der Zähler 7 einen weiteren Zählwert Z4 (FIG 6), so ändert das Ausgangssignal 7a den Signalpegel auf L, die Zählerstandsanzeige 4 wird weitergeschaltet und die Sperre 5 (FIG 8) wird in den Sperrzustand geschaltet, bis das Ausgangssignal (FIG 7) des Schieberegisters 9 ebenfalls den Signalpegel ändert.

## Ansprüche

1. Elektronischer Elektrizitätszähler mit einer Ansteuervorrichtung, die eine leistungsproportionale Impulsfolge an eine elektromagnetische Zählerstandsanzeige (4) und eine optische Anzeige (6) abgibt,
**dadurch gekennzeichnet,**
daß der Zählerstandsanzeige (4) bzw. der optischen Anzeige (6) eine Sperre (5) vorgeschaltet ist, die ein gleichzeitiges Ansteuern von Zählerstandsanzeige (4) und optischer Anzeige (6) verhindert.

2. Elektronischer Elektrizitätszähler nach Anspruch 1,
**dadurch gekennzeichnet,**
daß die Sperre (5) in Serie zur optischen Anzeige (6) geschaltet ist und von einem Ansteuerimpuls für die Zählerstandsanzeige (4) angesteuert wird.

3. Elektronischer Elektrizitätszähler nach einem der Ansprüche 1 oder 2,
**dadurch gekennzeichnet,**
daß die Zählerstandsanzeige (4) an zwei Ausgänge der Ansteuervorrichtung angeschlossen ist, wobei der Signalpegel beider Ausgänge zwischen binären Werten wechseln kann und daß das Signal der optischen Anzeige (6) dann gesperrt wird, wenn die beiden Ausgänge unterschiedliche Signalpegel aufweisen.

4. Elektronischer Elektrizitätszähler nach Anspruch 1, wobei die leistungsproportionale Impulsfolge der Zählerstandsanzeige (4) und der optischen Anzeige (6) über einen Teiler zugeführt sind und die Zählerstandsanzeige (4) und die optische Anzeige (6) an Ausgänge des Teilers (7) mit verschiedenen Teilerverhältnissen angeschlossen sind, **dadurch gekennzeichnet,** daß ein erster Ausgang des Teilers (7) mit einem D-Eingang eines Schieberegisters (9) und mit einem ersten Anschluß der Zählerstandsanzeige (4) verbunden ist, daß ein Ausgang des Schieberegisters (9) mit einem zweiten Anschluß der Zählerstandsanzeige (4) verbunden ist und daß der Ausgang eines Taktgebers (8) mit dem Clock-Eingang des Schieberegisters verbunden ist.

5. Elektronischer Elektrizitätszähler nach Anspruch 4,

**dadurch gekennzeichnet,**

daß ein erster Eingang eines Exklusiv-ODER-Gatters (10) mit dem ersten Anschluß der Zählerstandsanzeige (4) und ein zweiter Eingang des Exklusiv-ODER-Gatters (10) mit dem zweiten Anschluß der Zählerstandsanzeige (4) verbunden ist und daß ein Ausgangssignal des Exklusiv-ODER-Gatters (10) die Sperre (5) in den Sperrzustand versetzt.

86 P 3454

FIG 1

FIG 2

86 P 3454

FIG 9

FIG 8

FIG 7

FIG 6

FIG 5

FIG 4

FIG 3

$Z_1$  $Z_2$

$Z_4$

$Z_3$

$t_2$  $t_1$

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | DE-A-2 747 385 (SIEMENS AG) <br> * Seite 4, Zeilen 4-14; Seite 8, Zeile 27 - Seite 9, Zeile 14; Figur 1 * <br> --- | 1,4 | G 01 R 21/127 <br> G 01 R 21/133 |
| D,A | TECHNISCHES MESSEN ATM, Band 45, Nr. 11, November 1978, Seiten 407-411; G. STEINMÜLLER: "Ein genauer elektronischer Elektrizitätszähler" <br> * Seite 407, linke Spalte, Zeile 14 - Seite 408, linke Spalte, Zeile 3; Figur 2 * <br> --- | 1 | |
| A | LANDIS & GYR-MITTEILUNGEN, Band 19, Nr. 1, 1972, Seiten 9-16; H. VONARBURG et al.: "Elektronischer Elektrizitätszähler hoher Präzision" <br> * Seite 14, mittlere Spalte, Zeile 6 - Seite 14, rechte Spalte, Zeile 17; Figur 10 * <br> ----- | 1 | |

**RECHERCHIERTE SACHGEBIETE (Int. Cl.4)**

G 01 R

Der vorliegende Recherchenbericht wurde für alle Patentansprüche erstellt

| Recherchenort | Abschlußdatum der Recherche | Prüfer |
|---|---|---|
| DEN HAAG | 01-03-1988 | PENZKOFER, B. |